# EUROPEAN PATENT SPECIFICATION

(11) **EP 1 008 675 B1**
(45) Date of publication and mention of the grant of the patent: **27.10.2004**
(21) Application number: 98310107.2
(22) Date of filing: 10.12.1998
(51) Int. Cl.: C23F 11/14, C23C 22/52, C23C 22/68, H05K 3/28, C23F 11/08, B23K 1/20

(54) **Copper pretreatment for tin solder alloy deposition**
Vorbehandlung von Kupfer zum Abscheiden eines Zinnlegierungslotes
Prétraitement de cuivre avant le dépôt d'une soudure en alliage d'étain

(43) Date of publication of application: 14.06.2000
(73) Proprietor: INTERNATIONAL BUSINESS MACHINES CORPORATION, Armonk, NY 10504 (US)
(72) Inventor: Cavallotti, Pietro Luigi, 20131 Milano (IT); Cereda, Flavio, 20093 Cologno Montzese (Milano) (IT); Sirtori, Vittorio, 20136 Milano (IT); Zambon, Franco, 20063 Cernusco sul Naviglio (Milano) (IT)
(74) Representative: Burt, Roger James, Dr.

(56) References cited:
- EP-A- 0 364 132
- EP-A- 0 428 383
- EP-A- 0 541 318
- EP-A- 0 627 499
- DE-A- 4 444 388
- GB-A- 2 104 107
- PATENT ABSTRACTS OF JAPAN vol. 003, no. 046 (C-043), 18 April 1979 -& JP 54 020929 A (KURITA WATER IND LTD;OTHERS: 01), 16 February 1979
- DATABASE WPI Section Ch, Week 9738 Derwent Publications Ltd., London, GB; Class E19, AN 97-403262 XP002103099 & CN 1 112 601 A (BEIJING CHEM INST MIN CHEM IND), 29 November 1995
- PATENT ABSTRACTS OF JAPAN vol. 018, no. 344 (C-1218), 29 June 1994 & JP 06 081160 A (JAPAN ENERGY CORP), 22 March 1994
- PATENT ABSTRACTS OF JAPAN vol. 016, no. 501 (C-0996), 16 October 1992 & JP 04 183874 A (SHIKOKU CHEM CORP), 30 June 1992
- BAKSZT M.: "Providing solderability retention by means of chemical inhibtors" METAL FINISHING., vol. 83, no. 1, January 1985, pages 35-38, XP002103089 HACKENSACK, NJ US

## Description

The present invention relates to a method for protecting a copper surface, particularly in the manufacturing of electronic circuit boards.

The use of tin base solder alloys is common in electronic applications, particularly in the manufacturing of printed circuit boards (PCB), for assembly of components onto the boards, providing mechanical and electrical connection. These tin solder alloys are useful in joining integrated circuit chips to chip carriers and substrates, joining chip carriers to substrates, and joining circuitisation lands and pads in multilayer printed circuit boards.

In the manufacturing of a microelectronic package, it is common practice to attach a component onto a printed circuit board or the like, for example by surface mounting utilizing a solder connection. For this purpose, the board features a circuit trace including a pad that constitutes a first surface for the connection; similarly, the component includes a second surface, for example a contact.

The interconnection method comprises the steps of applying a solder alloy on the Cu substrate, typically onto the pad included in the printed circuit board.

The electronic components to be joined with the board are then brought into contact with the solder layer. The solder alloy is heated to cause the solder alloy to melt and reflow; heating may be by vapour phase reflow, infrared reflow, laser reflow, or the like. Upon cooling, the solder alloy resolidifies and bonds to the surfaces to complete the connection. The solder connection not only physically attaches the component to the board, but also electrically connects the trace on the board and the contact of the component to conduct electrical current to and from the component for processing.

The oxidation of a copper surface exposed to the air is a well known problem, not only in the manufacturing of electronic modules. The oxidation of copper pads of a PCB affects the solderability of the copper surface with the tin based alloy and this can cause problems in the assembly of the electronic module, particularly when the PCB is exposed to air for a prolonged period before being processed. For this reason the PCB is usually treated with chemical solutions which protect the copper from oxidation.

One of the known techniques used for protecting copper surfaces from corrosion, especially in the field of electronic circuit boards, is the Organic Solderability Preservative coating as described for example in "Corrosion Protection of Copper Using Organic Solderability Preservatives" by I.Artaki et al. Circuit World Vol.19, No.3 1993 pagg. 40-45. These organic coatings are usually based on azole or its derivates. Azoles react with metallic copper forming a film which helps to inhibite copper oxidation without compromising the solderability of the copper surface. US patent 3,295,917 discloses inhibiting copper corrosion by coating with benzotriazole. US patent 3,933,531 discloses a preservative treatment with 2-alkyl imidazoles. US patent 4,373,656 discloses a method for preserving a copper surface by immersing in imidazole.

As mentioned above, it is known to bathe the PCB in a solution containing BenzoTriAzole (BTA). A commercially available BTA based product is, for example, Entek56 produced by Enthone-Omi Inc.

However the prior art treatments are not always satisfactory, especially during the soldering process when the PCB undergoes high temperature.

Therefore an improved treatment for the copper surface would be highly desirable.

It is an object of the present invention to provide a technique which alleviates the above drawbacks.

According to the present invention we provide a method for preserving solderabilty properties of a copper surface comprising the step of treating the copper surface with a solderability preservative solution comprising:
- benzotriazole in a molar concentration of 0.001 to 0.5; and
- a zinc salt in a molar concentration of 0.1 to 1.

Also, according to the present invention, we provide a method for soldering a metallic component on a copper surface with a tin base alloy, the method comprising the step of pretreating the copper surface with the above protecting method.

The addition of the zinc (Zn) salts in the pretreatment solution gives substantial improvements to the copper (Cu) surface characteristics. The Cu surface oxidation decreased, both during soldering and the exposure to atmosphere; the Cu surface wettability is substantially improved, even after long time at relatively high temperature; and the adhesion of the tin (Sn) solder alloy is increased.

The present invention takes advantage of the fact that Zn forms a complex with BTA, in presence of Cu increasing the stability of layer adsorbed on the surface and giving to the interface the advantages described above.

According to the present invention the Zn salt is added to a treatment solution containing an organic substance for inhibiting copper oxidation (e.g. benzotriazole or benzimidazole) and adequately complexed. The pH of the solution can be varied in the range 5-8. According to a preferred embodiment a 7.5 pH has been reached by the addition of ammonia. The quantity of the components should be in the following ranges:

| | |
|---|---|
| Zn salt | 0.1-1 mol |
| BTA | 0.001-0.5 mol |
| (molar ratio) amine/zinc salt | 1-2 |
| (molar ratio) organic acid/zinc salt | 1-3 |
| pH | 5-8 |

According to a preferred embodiment the bath solution is prepared dissolving a Zn salt in water; then an amine and an organic acid are provided to complex the Zn salt and buffer the bath solution. The solution is then stabilized at 7.5 PH by the addition of ammonia. Finally BTA is added and the solution is stirred and heated. More specifically, as an example of a preferred embodiment, 45 g of zinc acetate Zn(CH₃COO)₂2H₂O, is dissolved in 200 ml of water; the complexants used are 50 ml of TriEthanolAmine (TEA) and 25 ml of acetic acid CH₃COOH. Then the BTA is added in the quantity of 0.1 g and the volume of the solution is increased to 500 ml by addition of water. The addition of BTA can be done by directly adding 0.1 g to the solution, add the water to reach the volume of 500ml and then stirring and heating (T = 40-70 C) until a limpid solution is obtained.

Alternatively the BTA can be previously dissolved in an alcoholic solution (5 g of BTA in 50 ml of ethanol) and then added to the above solution (1 ml of the alcoholic solution). In this way no heating is required and only a few minutes of stirring will give a limpid solution.

In order to increase the wettability of the copper surface to be treated with the above solution, a surfactant can be added. This is particularly useful for facilitating the wettability of "via holes" in a Printed Circuit Board. According to a preferred embodiment a commercially available product SANDOPAN ECO produced by CLARIANT has been used, but any other similar product can be used (e.g. TRITON DF16 produced by ROHM & HAAS).

By immersing a copper surface (e.g. a Printed Circuit Board with copper circuits) in the above described solution, Zn is deposited on the copper surface.

A copper surface treated with the preservative solution according to a preferred embodiment of the present invention has been compared with another surface treated with a prior art solution containing 0.2g/l of BTA.

Then the copper surface specimens have been heated at 240C for 2 min and left exposed to the atmosphere at room temperature for 24 hours for simulating the actual conditions at which the PCB are exposed during the manufacturing processing (soldering cycles and storage).

We will refer to the solution according to a preferred embodiment of the present invention as ZAB (from Zn Added BTA) as opposed to simply BTA which is the prior art solution.

Laboratory tests have been performed using ESCA-XPS measurements with monochromatic Al Kalfa X-ray source (1486.67 eV); pass energy 29.35 eV, sputtering rate 2nm/min, detector/sample angle 45.

The results obtained are as follows:

| ZBA treatment: | | | | | |
|---|---|---|---|---|---|
| | C | N | O | Cu | Zn |
| surface | 31 | 6 | 34 | 19 | 10 |
| 1.7nm sputt. | 5 | 3 | 12 | 71 | 9 |
| 5.1nm sputt. | 3 | 2 | 3 | 89 | 3 |
| 10nm sputt. | 2 | 2 | - | 95 | 1 |

| BTA treatment | | | | |
|---|---|---|---|---|
| | C | N | O | Cu |
| surface | 36 | 7 | 32 | 25 |
| 1.7nm sputt. | 7 | 4 | 25 | 64 |
| 5.1nm sputt. | 9 | 4 | 9 | 78 |
| 10nm sputt. | - | - | - | 100 |

From the tables above it is clear that the ZAB treatment caused a decrease of oxidation when the copper surface has been heated and exposed to air, which is the most critical condition for a Printed Circuit Board. Looking at the percentage of Oxygen at 1.7nm depth it is half than in the case of prior art BTA treatment; at 5.1nm it is one third.

As mentioned above, another advantage of using the pretreatment according to the present invention is the improvement of the copper surface wettability with a tin (Sn) solder alloy. Wettability is an indication of how completely and quickly the molten solder can cover a solid surface. Wettability tests by measuring the stripping force with a wetting balance have been performed. Two copper surfaces, one treated with the BTA prior art solution, the other with the ZAB solution described above, have been immersed in a liquid eutectic Sn-Pb alloy at 215C and fluxed with a suitable solution (Kester 450 33% in IPA). Then they have been heated at 240C for 2 min and kept exposed to the atmosphere for 24 hours. The results were as follows:

| | | |
|---|---|---|
| ZAB | 3.4mN after 2.3 sec | 6.9mN after 5.1 sec |
| BTA | 1.1mN after 3 sec | 4.7mN after 8.5 sec |

The test shows, for the surface pretreated with the ZAB solution described above, according to a preferred embodiment of the present invention, a better wettability in a shorter time of immersion.

Another advantage of the pretreatment solution of the present invention is the increased adhesion of a solder alloy to the copper surface. This is particularly useful in case a Pb free alloy is to be used. Tin-lead (Sn-Pb) alloys have been used for most electronic soldering operations. These alloys have been selected because of their mechanical strength, low relative cost, electrical conductivity and excellent wetting characteristics. In addition, Sn-Pb alloys provide a low melting temperature, which is important in electronic applications because many components and printed circuit boards use materials that are easily damaged by exposure to high temperature during manufacture or assembly. However, lead has been recognized as a health hazard, being toxic for workers and for the environment; recently governments have begun to urge the electronic industry to find alternatives to lead in order to reduce electronic industry worker lead exposure and reduce the amount of lead waste going back into the environment. Lead presence in the soldering alloys is particularly critical in the case of application for manufacturing the most recent generation of C-MOS; in fact the details are so thin in this kind of board, that the emission of α particles from the emitting radioisotope present in the lead can provoke serious problems for the device. Lead-free solder alloys known in the art, however present some problems. They exhibit poor soldering and metallurgical properties, that is small peel strength and low creep resistance. Particularly, they have shown poor mechanical properties at temperatures of the type typically encountered by microelectronic packages during use.

For the above reason the increased adhesion provided by the pretreatment solution described by the present invention can be very useful particularly in the case of Pb free alloy, e.g. tin-bismuth (Sn-Bi) alloy.

Using a free wheeling rotary test fixture, the peeling strength of several different copper joints soldered with eutectic SnBi alloy has been measured. This kind of machine is well known by those skilled in the art for measuring the properties of the solder joints.

The joints were obtained by soldering at 250 C in an industrial oven with N₂(O₂100ppm) atmosphere; Sn alloy was deposited as paste on rectangular Cu foils 25mm wide and 50mm long, thickness >50 micron, in contact with Sn coated rectangular Cu foils of 10mm width. The deposition was carried out on a 20x20 mm².

The machine parameters during the test run were:

| | |
|---|---|
| sampling rate | 10 points/sec |
| crosshead speed | 5 mm/min |
| humidity | 55% |
| temperature | 21 C |

The peeling length was established according to the run, in the range corresponding to a constant peeling load.

The results obtained are as follows:

| | Average peeling strength | Standard deviation |
|---|---|---|
| ZAB pretreatment | 1.10 N/mm | +-0.09 |
| BTA pretreatment | 0.87 N/mm | +-0.66 |

## Claims

1. A method for preserving solderabilty properties of a copper surface comprising the step of treating the copper surface with a solderability preservative solution comprising:
- benzotriazole in a molar concentration of 0.001 to 0.5; and
- a zinc salt in a molar concentration of 0.1 to 1.

2. The method of claim 1 wherein in the solution the zinc salt is zinc acetate Zn (CH₃COO)₂2H₂O.

3. The method of claim 2 wherein the solution further comprises an organic acid and an amine as complexing agent.

4. The method of claim 3 wherein the organic acid is acetic acid CH₃COOH.

5. The method of claim 3 or 4 wherein the amine is TriEthanolAmine (TEA).

6. The method of any preceding claim wherein the pH of the solution is between 5 and 8.

7. The method of claim 6 wherein the pH is controlled by the addition of ammonia.

8. The method of any claim 3 to 7 wherein in the solution the molecular ratio amine/zinc salt is between 1 and 2 and the molecular ratio organic acid/zinc salt is between 1 and 3.

9. A method for soldering a metallic component on a copper surface with a tin base alloy, the method comprising the step of pretreating the copper surface with the method of any preceding claim.

10. A method for manufacturing a printed circuit board wherein the electronic components are soldered on the copper (Cu) substrate using a tin (Sn) solder alloy, the method comprising the soldering method of claim 9.

11. The method of claim 10 wherein the Sn alloy is lead (Pb) free.

12. The method of claim 11 wherein the lead free alloy is a tin-bismuth (Sn-Bi) alloy.

## Patentansprüche

1. Verfahren zur Erhaltung der Lötbarkeit einer Kupferoberfläche, welches den Schritt des Behandelns der Kupferoberfläche mit einer Lösung zur Erhaltung der Lötbarkeit umfasst, wobei die Lösung Folgendes umfasst:
- Benzotriazol in einer molaren Konzentration von 0,001 M bis 0,5 M; und
- ein Zinksalz in einer molaren Konzentration von 0,1 M bis 1 M.

2. Verfahren nach Anspruch 1, bei dem das Zinksalz in der Lösung Zinkacetat Zn(CH₃COO)₂·2H₂O ist.

3. Verfahren nach Anspruch 2, bei dem die Lösung ferner eine organische Säure und ein Amin als Komplexbildner umfasst.

4. Verfahren nach Anspruch 3, bei dem die organische Säure Essigsäure CH₃COOH ist.

5. Verfahren nach Anspruch 3 oder 4, bei dem das Amin Triethanolamin (TEA) ist.

6. Verfahren nach einem der vorangehenden Ansprüche, bei dem der pH-Wert der Lösung zwischen 5 und 8 liegt.

7. Verfahren nach Anspruch 6, bei dem der pH-Wert durch Zugabe von Ammoniak gesteuert wird.

8. Verfahren nach einem der Ansprüche 3 bis 7, bei dem in der Lösung das Molverhältnis Amin/Zinksalz zwischen 1 und 2 und das Molverhältnis organische Säure/Zinksalz zwischen 1 und 3 liegt.

9. Verfahren zum Löten eines metallischen Bauelements auf eine Kupferoberfläche mittels einer Legierung auf der Basis von Zinn, wobei das Verfahren den Schritt der Vorbehandlung der Kupferoberfläche durch das Verfahren nach einem der vorangehenden Ansprüche umfasst.

10. Verfahren zum Herstellen einer gedruckten Leiterplatte, wobei die elektronischen Bauelemente mittels eines Zinnlegierungslotes (Sn) auf das Kupfersubstrat (Cu) gelötet werden und das Verfahren das Lötverfahren nach Anspruch 9 umfasst.

11. Verfahren nach Anspruch 10, bei dem die Sn-Legierung frei von Blei (Pb) ist.

12. Verfahren nach Anspruch 11, bei dem die bleifreie Legierung eine Zinn-Bismut-Legierung (Sn-Bi) ist.

## Revendications

1. Procédé permettant de préserver les propriétés de brasabilité d'une surface de cuivre et comprenant les phases qui consistent à traiter la surface de cuivre avec une solution de préservation de brasabilité comprenant :
- du benzotriazole à une concentration molaire de 0,001 à 0,5 ; et
- un sel zincique à une concentration molaire de 0,1 à 1.

2. Procédé selon la revendication 1, où le sel zincique de la solution est de l'acétate de zinc Zn(CH₃COO)₂2H₂O.

3. Procédé selon la revendication 2 où la solution comprend en outre un acide organique et une amine servant d'agent complexant.

4. Procédé selon la revendication 3 où l'acide organique est de l'acide acétique CH₃COOH.

5. Procédé selon la revendication 3 ou 4 où l'amine est de la triéthanolamine (TEA).

6. Procédé selon l'une quelconque des revendications précédentes où le pH de la solution est compris entre 5 et 8.

7. Procédé selon la revendication 6 où le pH est contrôlé par l'ajout de gaz ammoniac.

8. Procédé selon l'une quelconque des revendications 3 à 7 où, dans la solution, le rapport moléculaire amine /sel zincique est compris entre 1 et 2 et le rapport moléculaire acide organique/ sel zincique est compris entre 1 et 3.

9. Procédé permettant de souder un composant métallique sur une surface de cuivre avec un alliage à base d'étain, le procédé comprenant la phase qui consiste à prétraiter la surface de cuivre au moyen d'un procédé selon l'une quelconque des revendications précédentes.

10. Procédé permettant de fabriquer une plaquette de circuits imprimés où les composants électriques sont soudés sur le substrat en cuivre (Cu) à l'aide d'une soudure en alliage d'étain (Sn), le procédé comprenant le procédé de soudure selon la revendication 9.

11. Procédé selon la revendication 10 où l'alliage d'étain (Sn) ne comporte pas de plomb (Pb).

12. Procédé selon la revendication 11 où l'alliage sans plomb est un alliage d'étain et de bismuth (Sn-Bi).
